# EUROPEAN PATENT APPLICATION

(11) **EP 4 764 522 A1**
(43) Date of publication of application: **24.06.2026**
(21) Application number: 25803872.8
(22) Date of filing: 26.02.2025
(51) Int. Cl.: G01R 31/36, G01R 31/3835, G01R 19/10, G01R 19/25, G01R 19/165, G01R 19/30, G01R 1/30, H03M 1/12

(54) **VOLTAGE CONVERSION DEVICE AND VOLTAGE CONVERSION METHOD**

(30) Priority: 13.05.2024 KR 20240062711
(71) Applicant: LG Energy Solution, Ltd., Seoul 07335 (KR)
(72) Inventor: JUNG, Jae Sang, Daejeon 34122 (KR)
(74) Representative: Goddar, Heinz J.
(86) International application number: PCT/KR2025/002673
(87) International publication number: WO 2025/239514

(57) **Abstract**

According to some embodiments, a voltage conversion device includes a voltage generator configured to provide a reference voltage, an amplifier configured to generate an amplified signal based on a difference between a battery voltage output by a battery and the reference voltage, a first converter configured to convert the amplified signal into a first digital voltage, a second converter configured to convert the reference voltage into a second digital voltage, and a computation unit configured to calculate a final digital voltage of the battery based on the first digital voltage and the second digital voltage.

## Description

### TECHNICAL FIELD

### Cross-reference to Related Applications

This application claims priority from Korean Patent Application No. 10-2024-0062711, filed on May 13, 2024, the disclosure of which is incorporated by reference herein.

### Technical Field

Embodiments disclosed in this document relate to a voltage conversion device and voltage conversion method.

### BACKGROUND ART

Recently, research and development on secondary batteries have been actively conducted. Here, secondary batteries are batteries that can be charged and discharged, and may be interpreted as including both conventional Ni/Cd batteries, Ni/MH batteries, and recent lithium-ion batteries. Among secondary batteries, lithium ion batteries may have higher energy density than conventional Ni/Cd batteries, Ni/MH batteries, etc. and may be manufactured to be small and lightweight, and thus may have high usability as a power source for mobile devices. Recently, the scope of use of the secondary batteries has expanded to include a power source for electric vehicles, and the secondary batteries are attracting attention as a next-generation energy storage medium.

An analog-to-digital converter (ADC) that measures an analog voltage of a secondary battery and converts the measured analog voltage value to a digital value may be utilized. The higher the resolution bit of the ADC, the more accurately the digital voltage value can express the analog voltage value. For example, an ADC with a resolution of 2 bits can express a range of an input voltage as one of four digital values, while a 3-bit ADC may express the range of the input voltage as one of eight digital values. Meanwhile, the voltage of a battery cell is mainly distributed within a specific range, such as 2 V or more and 5 V or less, and may hardly be measured in an area outside that range. When an output digital value of the ADC is allocated even for an area where the voltage is not measured, an output resolution of the ADC is wasted, which may be problematic.

### DISCLOSURE OF THE INVENTION

### TECHNICAL PROBLEM

Embodiments disclosed in this document provide a voltage conversion device and voltage conversion method that can solve the problem of the output resolution of ADC being wasted for areas where the voltage of a battery cell is not measured.

The technical problems of the embodiments disclosed in this document are not limited to the technical problems mentioned above, and other technical problems that are not mentioned may be clearly understood by those skilled in the art from the descriptions below.

### TECHNICAL SOLUTION

According to some embodiments, a voltage conversion device includes a voltage generator configured to provide a reference voltage, an amplifier configured to generate an amplified signal based on a difference between a battery voltage output by a battery and the reference voltage, a first converter configured to convert the amplified signal into a first digital voltage, a second converter configured to convert the reference voltage into a second digital voltage, and a computation unit configured to calculate a final digital voltage of the battery based on the first digital voltage and the second digital voltage.

According to some embodiments, the amplifier may be configured to generate the amplified signal by multiplying the difference between the battery voltage and the reference voltage between an upper limit voltage and a lower limit voltage by an amplification gain.

According to some embodiments, the computation unit may be configured to calculate a final digital voltage by adding a value obtained by dividing the first digital voltage by the amplification gain to the second digital voltage.

According to some embodiments, a resolution of the first digital voltage may be a value obtained by dividing a section less than or equal to the upper limit voltage and greater than or equal to the lower limit voltage by a first conversion resolution of the first converter, and a resolution of the final digital voltage may be a value obtained by dividing a section less than or equal to the upper limit voltage and greater than or equal to the reference voltage by the first conversion resolution.

According to some embodiments, the battery may include a plurality of battery cells connected in series, and the final digital voltage may include a digital value of a voltage output by any one battery cell among the plurality of battery cells.

According to some embodiments, the battery voltage may be output as a value that changes according to a state of charge (SOC) of the battery, and the reference voltage may be set to a value lower than a lower limit of an output voltage range of the battery voltage.

According to some embodiments, a voltage conversion method includes providing, through a voltage generator, a reference voltage, generating, through an amplifier, an amplified signal based on a difference between a battery voltage output by a battery and the reference voltage, converting, through a first converter, the amplified signal into a first digital voltage, converting, through a second converter, the reference voltage into a second digital voltage, and calculating, through a computation unit, a final digital voltage of the battery based on the first digital voltage and the second digital voltage.

According to some embodiments, the generating of the amplified signal may include generating the amplified signal by multiplying the difference between the battery voltage and the reference voltage between an upper limit voltage and a lower limit voltage by an amplification gain.

According to some embodiments, the calculating of the final digital voltage may include calculating a final digital voltage by adding a value obtained by dividing the first digital voltage by the amplification gain to the second digital voltage.

According to some embodiments, a resolution of the first digital voltage may be a value obtained by dividing a section less than or equal to the upper limit voltage and greater than or equal to the lower limit voltage by a first conversion resolution of the first converter, and a resolution of the final digital voltage may be a value obtained by dividing a section less than or equal to the upper limit voltage and greater than or equal to the reference voltage by the first conversion resolution.

According to some embodiments, the battery may include a plurality of battery cells connected in series, and the final digital voltage may include a digital value of a voltage output by any one battery cell among the plurality of battery cells.

According to some embodiments, the battery voltage may be output as a value that changes according to a state of charge (SOC) of the battery, and the reference voltage may be set to a value lower than a lower limit of an output voltage range of the battery voltage.

### ADVANTAGEOUS EFFECTS

According to the embodiments disclosed in this document, a voltage conversion device and voltage conversion method that can solve the problem of the output resolution of ADC being wasted for areas where the voltage of a battery cell is not measured can be provided.

The technical effects according to the embodiments disclosed in this document are not limited to the effects mentioned above, and other effects not mentioned will be clearly understood by those skilled in the art according to the disclosure of this document.

### BRIEF DESCRIPTION OF THE DRAWINGS

FIG. 1 illustrates an environment in which a voltage conversion device according to some embodiments operates.
FIG. 2 illustrates components constituting a voltage conversion device according to some embodiments.
FIG. 3 illustrates how a conventional ADC converts a battery voltage.
FIG. 4 illustrates how a voltage conversion device according to some embodiments converts a battery voltage.
FIG. 5 illustrates how an analog battery voltage is converted into a digital battery voltage in a conventional ADC.
FIG. 6 illustrates how an analog battery voltage is converted into a digital battery voltage in a voltage conversion device according to some embodiments.
FIG. 7 illustrates steps constituting a voltage conversion method according to some embodiments.

### MODE FOR CARRYING OUT THE INVENTION

Hereinafter, embodiments described in this document are described with reference to the accompanying drawings. However, this is not intended to limit the disclosure of this document to a specific embodiment, but should be understood to include various modifications, equivalents, and/or alternatives of the embodiments described in this document.

Embodiments of this document and the terms used therein are not intended to limit the technical features described in this document to a specific embodiment, but should be understood to include various modifications, equivalents, or alternatives of the embodiment. In connection with the description of the drawings, similar reference numerals may be used for similar or related components. The singular form of a noun corresponding to an item may include a single or a plurality of said items, unless the context clearly indicates otherwise.

In this document, each of phrases "A or B", "at least one of A and B", "at least one of A or B", "A, B, or C", "at least one of A, B, and C", and "at least one of A, B, or C" may include any one of the items listed together in the corresponding phrase among the phrases, or all possible combinations thereof. Terms such as "first", "second", "firstly", "secondly", "A", "B", "(a)", or "(b)" may be used merely to distinguish one component from another, and do not limit the components in any other respect (e.g., importance or order) unless specifically stated otherwise.

In this document, when a component (e.g., a first component) is referred to as being "connected", "coupled" or "joined" to another component (e.g., a second component), with or without the terms "functionally" or "communicatively", it means that the component can be connected to the other component directly (e.g., in a wired manner or wirelessly), or indirectly (e.g., through a third component).

The method according to the various embodiments disclosed in this document may be provided by being included in a computer program product. The computer program product may be traded between a seller and a buyer as a product. The computer program product may be distributed in the form of a machine-readable recording medium (e.g., compact disc read only memory (CD-ROM)), or distributed through an application store (e.g., Play Store^{™}), distributed directly between two user devices (e.g., smartphones), or distributed online (e.g., downloaded or uploaded). In the case of online distribution, at least a part of the computer program product may be temporarily stored or temporarily generated in a machine-readable recording medium, such as a memory of a manufacturer's server, an application store's server, or an intermediary server.

According to embodiments disclosed in this document, each of the components (e.g., modules or programs) described above may include a single or plurality of entities, and some of the plurality of entities may be separated and placed in other components. According to embodiments disclosed in this document, one or more of the components or operations described above may be omitted, or one or more other components or operations may be added. Alternatively or additionally, a plurality of components (e.g., modules or programs) may be integrated into a single component. In such a case, the integrated component may perform one or more functions of each of the plurality of components identically or similarly to those performed by the corresponding component among the plurality of components prior to the integration. According to various embodiments, the operations performed by a module, program, or other component may be performed sequentially, in parallel, repeatedly, or heuristically, or one or more of the operations may be performed in a different order, omitted, or performed by being added with one or more other operations.

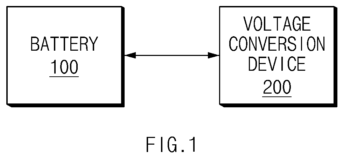

FIG. 1 illustrates an environment in which a voltage conversion device according to some embodiments operates.

Referring to FIG. 1, a voltage conversion device 200 may convert an analog voltage output by a battery 100 into a digital voltage.

The battery 100 may include a battery pack, and the battery pack may include a plurality of battery modules. Each battery module may include a plurality of battery cells. The voltage output by the battery pack, the battery module, and/or the battery cell may be measured by the voltage conversion device 200 in the form of an analog voltage, and the measured analog voltage may be converted into a digital voltage by the voltage conversion device 200.

The voltage conversion device 200 may include an analog-to-digital converter (ADC). The ADC of the voltage conversion device 200 may have a resolution bit. The voltage conversion device 200 may perform voltage conversion in a direction that maximizes the resolution bit of the ADC. According to the embodiment, the voltage conversion device 200 may improve the resolution efficiency of the ADC by using a reference voltage, and the reference voltage may be determined based on a range in which the voltage of the battery 100 is mainly measured.

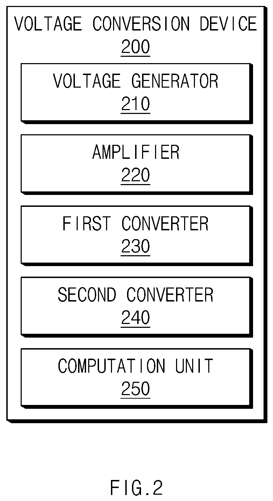

FIG. 2 illustrates components constituting a voltage conversion device according to some embodiments.

Referring to FIG. 2, the voltage conversion device 200 may include a voltage generator 210, an amplifier 220, a first converter 230, a second converter 240, and a computation unit 250. However, the present invention is not limited thereto, and some components may be omitted from the voltage conversion device 200, or other general-purpose components may be further included in the voltage conversion device 200.

The voltage generator 210 may include a DC voltage source. The amplifier 220 may include an operational amplifier (op-amp). The first converter 230 and the second converter 240 may include a typical n-bit analog-to-digital converter (ADC) circuit. The computation unit 250 may include an arithmetic operation circuit, etc. For example, the arithmetic operation circuit may be implemented by a memory and/or a processor. The processor may be implemented in the form of at least one of a logic gate array, a microprocessor, a CPU, a GPU, and an AP. The memory may be implemented in the form of a nonvolatile device such as a ROM, a PROM, an EPROM, an EEPROM, a flash memory, a PRAM, an MRAM, an RRAM, an FRAM, or a volatile device such as a DRAM, an SRAM, an SDRAM, a PRAM, or the like, and may be implemented in the form of a HDD, an SSD, an SD, a Micro-SD, or a combination thereof.

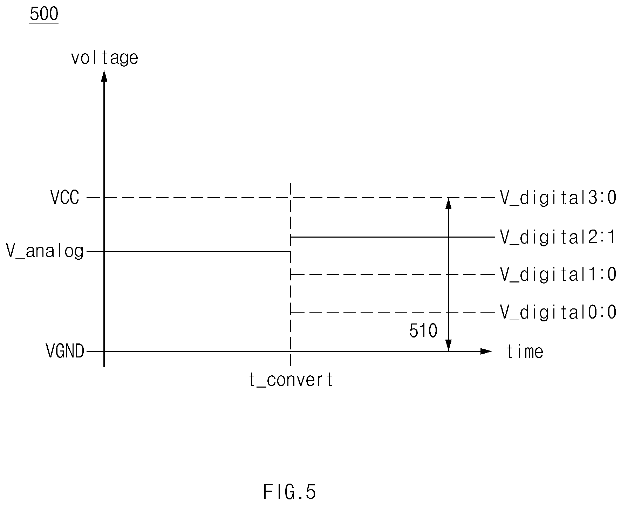

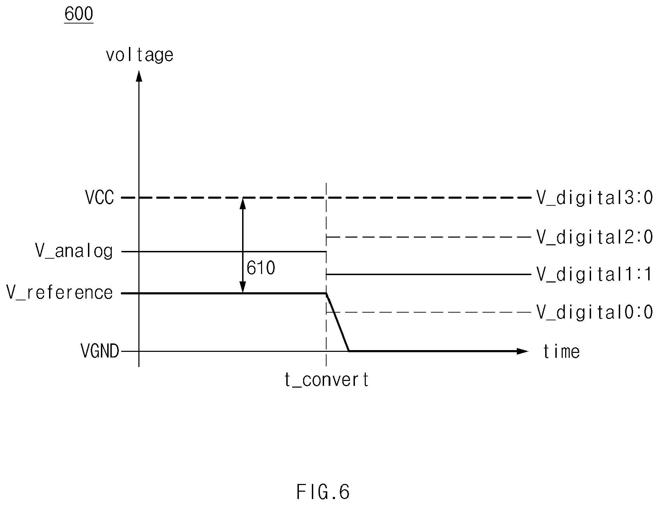

The voltage generator 210 may be configured to provide a reference voltage. The reference voltage may be determined based on a range in which the voltage of the battery 100 is mainly measured. For example, the voltage of the battery 100 may be mainly measured in a range of 2.5 V or more and 4.5 V or less, and the reference voltage may be set to 2 V. As a first voltage range 510 of FIG. 5 decreases to a second voltage range 610 of FIG. 6, a range to which the resolution of the voltage conversion device 200 is applied may decrease by using a reference voltage, and thereby the actual conversion resolution may increase.

The amplifier 220 may be configured to generate an amplified signal based on a difference between the battery voltage output by the battery 100 and the reference voltage. Since the reference voltage may be set to be lower than a measurable minimum value of the battery voltage, a difference between the battery voltage and the reference voltage may have a positive value, and the difference value may be amplified to a value between an upper limit voltage VCC and a lower limit voltage GND.

The first converter 230 may be configured to convert an amplified signal into a first digital voltage. Since the first converter 230 converts the amplified signal having a narrower voltage range instead of directly converting the battery voltage having a wider voltage range, the first converter 230 may have substantially higher conversion resolution based on the same resolution bit.

The second converter 240 may be configured to convert the reference voltage into a second digital voltage. Since the amplified signal corresponding to the difference between the battery voltage and the reference voltage is converted instead of the battery voltage in the first converter 230, the reference voltage may be converted to a second digital voltage to compensate for the influence caused by the subtraction of the reference voltage.

The computation unit 250 may be configured to calculate a final digital voltage of the battery 100 based on the first digital voltage and the second digital voltage. Since the first digital voltage corresponds to a value obtained by amplifying the difference between the battery voltage and the reference voltage by an amplification ratio (gain), the final digital voltage may be calculated by adding the second digital voltage after correcting the first digital voltage based on the amplification ratio.

According to the embodiment, the amplifier 220 may be configured to generate an amplified signal by multiplying the difference between the battery voltage and the reference voltage between the upper limit voltage and the lower limit voltage by an amplification gain. For example, when the battery voltage is 3.6 V in analog value, the reference voltage is 2.2 V, and the amplification gain is 2.0, the amplified signal may have a value of 2.8 V.

According to the embodiment, the computation unit 250 may be configured to calculate the final digital voltage by adding a value obtained by dividing the first digital voltage by the amplification gain to the second digital voltage. For example, when a resolution bit of the voltage conversion device 200 is 2, the voltage conversion device 200 may convert an input analog voltage into one of four digital voltage values. When the upper limit voltage VCC is 5.0 V and the lower limit voltage GND is 0 V, the four digital voltage values may be 5.0 V, 3.75 V, 2.5 V, and 1.25 V. When the amplified signal is 2.8 V, the first digital voltage may be 2.5 V. When the reference voltage is 2.2 V, the second digital voltage may be 2.2 V. In this case, the final digital voltage may be 3.45 V. In the case of the conventional method, when the battery voltage is 3.6 V, the output of the ADC becomes 3.75 V, while the voltage conversion device 200 may output a final digital voltage of 3.45 V. Therefore, a higher conversion resolution may be achieved than with the conventional method using the same resolution bits.

According to the embodiment, the resolution of the first digital voltage may be a value obtained by dividing a section less than or equal to the upper limit voltage and greater than or equal to the lower limit voltage by a first conversion resolution of the first converter 230, and the resolution of the final digital voltage may be a value obtained by dividing a section less than or equal to the upper limit voltage and greater than or equal to the reference voltage by the first conversion resolution. For example, when the upper limit voltage VCC is 5.0 V, the lower limit voltage GND is 0 V, and the first conversion resolution of the first converter 230 is 2², the resolution of the first digital voltage may be 1.25 V, which may be the same as the resolution with a conventional ADC. On the other hand, when the reference voltage is 2.2 V, the resolution of the final digital voltage may be (5.0 V - 2.2 V)/4 = 0.7 V. Therefore, the voltage conversion device 200 may achieve a higher resolution than with the conventional ADC.

According to the embodiment, the battery 100 may include a plurality of battery cells connected in series, and the final digital voltage may include a digital value of a voltage output by any one battery cell among the plurality of battery cells. The voltage conversion device 200 may convert a cell voltage output by any cell among the plurality of battery cells into a digital value. In this case, a voltage applied to both ends of any cell may be input to a positive (+) terminal of the amplifier 220.

According to the embodiment, the battery voltage may be output as a value that changes according to a state of charge (SOC) of the battery 100, and the reference voltage may be set to a value lower than a lower limit value of an output voltage range of the battery voltage. For example, the battery cell of the battery 100 may have a value around 2.5 V when the SOC is 0%, and may have a value around 4.3 V when the SOC is 100%. The output voltage range of 2.5 V to 4.3 V may be changed depending on the specifications of the battery 100. For the range of 2.5 V to 4.3 V, the reference voltage may be set to a value lower than the lower limit value of 2.5 V. In this way, the resolution of the ADC may be prevented from being wasted on unnecessary areas.

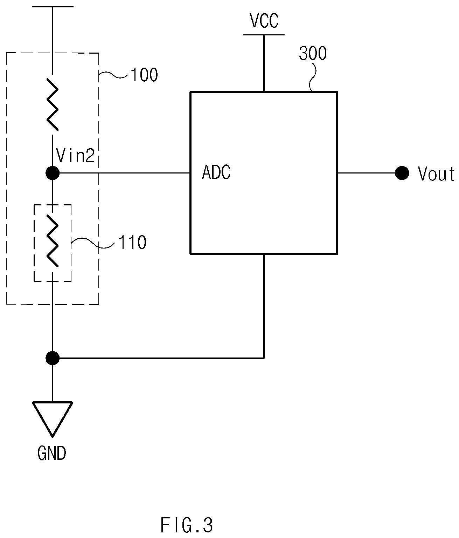

FIG. 3 illustrates how a conventional ADC converts a battery voltage.

Referring to Figure 3, a conventional ADC 300 may convert an analog voltage Vin2 output by a first battery cell 110 of the battery 100 into a digital voltage Vout. According to the embodiment, the analog voltage Vin2 may be formed by voltage distribution from an input voltage Vin1.

When the ADC 300 converts the analog voltage Vin2, a voltage range of GND or more to VCC or less may be distributed as the resolution of the ADC 300. In this case, since the voltage range from GND or more to VCC or less is excessively wider than the output range of the analog voltage Vin2, the resolution of the ADC 300 may be wasted for an area that is not the output range of the analog voltage Vin2.

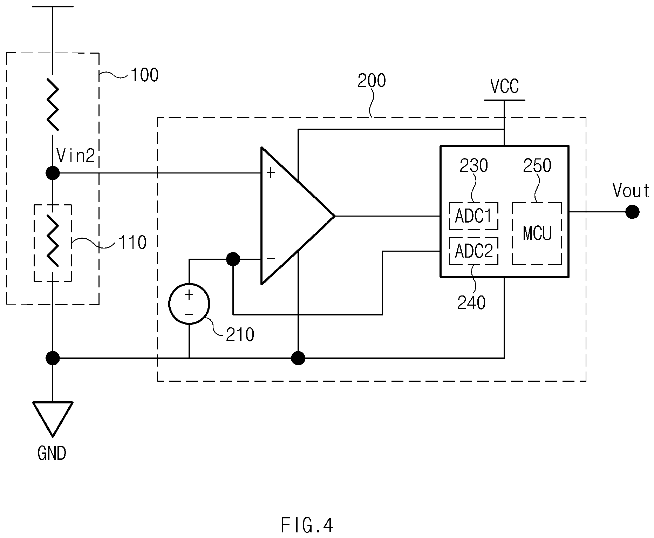

FIG. 4 illustrates how a voltage conversion device according to some embodiments converts a battery voltage.

Referring to FIG. 4, the voltage conversion device 200 may convert an analog voltage Vin2 output by the first battery cell 110 of the battery 100 into a digital voltage Vout. According to the embodiment, the analog voltage Vin2 may be formed by voltage division from an input voltage Vin1.

Compared to a conventional ADC 300, the voltage conversion device 200 may further include a voltage generator 210 and a second converter 240. A reference voltage may be generated by the voltage generator 210, and an amplifier 230 may amplify a difference between the analog voltage Vin2 and the reference voltage to generate an amplified signal. The first ADC 230 may convert the amplified signal into a first digital voltage, and the second ADC 240 may convert the reference voltage into a second digital voltage.

The computation unit 250 implemented with a microcontroller unit (MCU) or the like may output the final digital voltage Vout through computation on the first digital voltage and the second digital voltage. The voltage conversion device 200 may implement a higher practical resolution than with the conventional ADC 300 for the same ADC resolution by using a structure that further includes the voltage generator 210 and the second converter 240.

FIG. 5 illustrates how an analog battery voltage is converted into a digital battery voltage in a conventional ADC.

Referring to FIG. 5, a graph 500 illustrating how the analog battery voltage is converted into the digital battery voltage in the conventional ADC may be illustrated.

When a conversion point in time t_convert in the graph 500 is reached, an analog voltage V_analog output by the battery 100 may be converted into a first digital voltage V_digital0, V_digital1, V_digital2, or V_digital3. For example, a conventional ADC may have a 2-bit resolution and may output one of 2² digital output values.

The output voltage range of the analog voltage V_analog may be approximately 2.5 V or more and 4.3 V or less. However, a first voltage range 510 to which the resolution of the conventional ADC is applied may be greater than or equal to 0 V of GND and less than or equal to 5 V of VCC. Therefore, a conventional ADC may not be able to consider the output voltage range of the analog voltage V_analog, which may result in wasted resolution.

FIG. 6 illustrates how an analog battery voltage is converted into a digital battery voltage in a voltage conversion device according to some embodiments.

Referring to FIG. 6, a graph 600 illustrating how the analog battery voltage is converted into the digital battery voltage in the voltage conversion device may be illustrated.

In the graph 600, a reference voltage V_reference may be utilized, and a second voltage range 610 to which the resolution of the first converter 230 is applied may be narrower than the first voltage range 510 in the conventional ADC. Therefore, even if the same resolution bit is applied, the voltage conversion device 200 may have a higher practical resolution than with the conventional ADC.

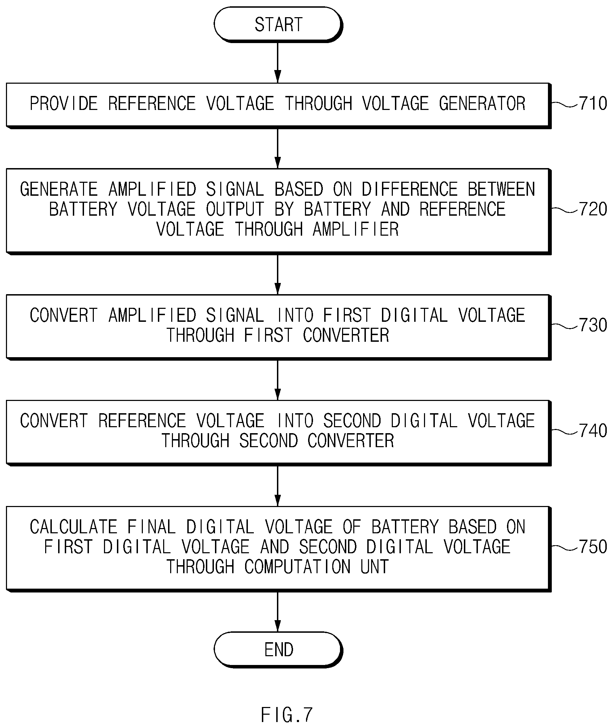

FIG. 7 illustrates steps that constitute a voltage conversion method according to some embodiments.

Referring to FIG. 7, a voltage conversion method 700 may include steps 710 to 750. However, the preset invention is not limited thereto, and some steps may be omitted or other general-purpose steps may be added, and the steps of the voltage conversion method 700 may be executed in a different order from the illustrated order.

The voltage conversion method 700 may be composed of steps that are processed in time series in the voltage conversion device 200. Therefore, even if the content is omitted below, the content described above for the voltage conversion device 200 may be equally applied to the voltage conversion method 700.

Steps 710 to 750 of the voltage conversion method 700 may be performed by the voltage generator 210, the amplifier 220, the first converter 230, the second converter 240, and the computation unit 250 of the voltage conversion device 200.

In step 710, the voltage conversion device 200 may perform a step of providing a reference voltage through the voltage generator.

In step 720, the voltage conversion device 200 may perform a step of generating an amplified signal based on the difference between the battery voltage output by the battery and the reference voltage through the amplifier.

In step 730, the voltage conversion device 200 may perform a step of converting the amplified signal into a first digital voltage through the first converter.

In step 740, the voltage conversion device 200 may perform a step of converting the reference voltage into a second digital voltage through the second converter.

In step 750, the voltage conversion device 200 may perform a step of calculating the final digital voltage of the battery based on the first digital voltage and the second digital voltage through the computation unit.

According to the embodiment, the voltage conversion method 700 may be implemented in the form of a computer program stored in a computer-readable storage medium. That is, the computer program may include instructions for implementing the voltage conversion method 700, and the instructions of the program may be stored in a computer-readable storage medium. The computer program may include a mobile application.

According to the embodiment, the computer-readable storage medium may include magnetic media such as a hard disk, a floppy disk, and a magnetic tape, optical media such as a CD-ROM, a DVD, magneto-optical media such as a floptical disk, and a hardware device specifically configured to store and execute computer program instructions such as a ROM, a RAM, a flash memory, etc. The computer program instructions may include a machine language code generated by a compiler and a high-level language code that may be executed by a computer using an interpreter, etc.

The terms "include," "configure," or "have" described above, unless specifically stated to the contrary, mean that the corresponding component may be included therein, and therefore should be interpreted as further including other components rather than excluding other components. All terms including technical or scientific terms have the same meaning as commonly understood by a person skilled in the art to which the embodiments disclosed in this document belong, unless otherwise defined. Terms commonly used, such as terms defined in the dictionary, should be interpreted as being consistent with the contextual meaning of the relevant technology, and should not be interpreted in an idealized or overly formal sense unless clearly defined in this document.

The above description is merely an illustrative description of the technical idea disclosed in this document, and those skilled in the art to which the embodiments disclosed in this document belong may make various modifications and variations without departing from the essential characteristics of the embodiments disclosed in this document. Accordingly, the embodiments disclosed in this document are not intended to limit the technical ideas of the embodiments disclosed in this document, but rather to describe them, and the scope of the technical ideas disclosed in this document is not limited by these embodiments. The scope of protection of the technical ideas disclosed in this document should be interpreted by the scope of the claims below, and all technical ideas within the equivalent scope should be interpreted as being included in the scope of the rights of this document.

### [Description of Symbols]

100: Battery 200: Voltage conversion device
210: Voltage generator 220: Amplifier
230: First converter 240: Second converter
250: Computation unit

## Claims

1. A voltage conversion device comprising:
an amplifier configured to generate an amplified signal based on a difference between a battery voltage output by a battery and the reference voltage;
a first converter configured to convert the amplified signal into a first digital voltage;
a second converter configured to convert the reference voltage into a second digital voltage; and
a computation unit configured to calculate a final digital voltage of the battery based on the first digital voltage and the second digital voltage.

2. The voltage conversion device of claim 1, wherein the amplifier is configured to generate the amplified signal by multiplying the difference between the battery voltage and the reference voltage between an upper limit voltage and a lower limit voltage by an amplification gain.

3. The voltage conversion device of claim 2, wherein the computation unit is configured to calculate a final digital voltage by adding a value obtained by dividing the first digital voltage by the amplification gain to the second digital voltage.

4. The voltage conversion device of claim 2, wherein a resolution of the first digital voltage is a value obtained by dividing a section less than or equal to the upper limit voltage and greater than or equal to the lower limit voltage by a first conversion resolution of the first converter, and
a resolution of the final digital voltage is a value obtained by dividing a section less than or equal to the upper limit voltage and greater than or equal to the reference voltage by the first conversion resolution.

5. The voltage conversion device of claim 1, wherein the battery comprises a plurality of battery cells connected in series, and
the final digital voltage comprises a digital value of a voltage output by any one battery cell among the plurality of battery cells.

6. The voltage conversion device of claim 1, wherein the battery voltage is output as a value that changes according to a state of charge (SOC) of the battery, and
the reference voltage is set to a value lower than a lower limit of an output voltage range of the battery voltage.

7. A voltage conversion method comprising:
providing, through a voltage generator, a reference voltage;
generating, through an amplifier, an amplified signal based on a difference between a battery voltage output by a battery and the reference voltage;
converting, through a first converter, the amplified signal into a first digital voltage;
converting, through a second converter, the reference voltage into a second digital voltage; and
calculating, through a computation unit, a final digital voltage of the battery based on the first digital voltage and the second digital voltage.

8. The voltage conversion method of claim 7, wherein the generating of the amplified signal comprises generating the amplified signal by multiplying the difference between the battery voltage and the reference voltage between an upper limit voltage and a lower limit voltage by an amplification gain.

9. The voltage conversion method of claim 8, wherein the calculating of the final digital voltage comprises calculating a final digital voltage by adding a value obtained by dividing the first digital voltage by the amplification gain to the second digital voltage.

10. The voltage conversion method of claim 8, wherein a resolution of the first digital voltage is a value obtained by dividing a section less than or equal to the upper limit voltage and greater than or equal to the lower limit voltage by a first conversion resolution of the first converter, and
a resolution of the final digital voltage is a value obtained by dividing a section less than or equal to the upper limit voltage and greater than or equal to the reference voltage by the first conversion resolution.

11. The voltage conversion method of claim 7, wherein the battery comprises a plurality of battery cells connected in series, and
the final digital voltage comprises a digital value of a voltage output by any one battery cell among the plurality of battery cells.

12. The voltage conversion method of claim 7, wherein the battery voltage is output as a value that changes according to a state of charge (SOC) of the battery, and
the reference voltage is set to a value lower than a lower limit of an output voltage range of the battery voltage.
